# EUROPEAN PATENT APPLICATION

(11) **EP 3 016 218 A1**
(43) Date of publication of application: **04.05.2016**
(21) Application number: 13889653.5
(22) Date of filing: 15.07.2013
(51) Int. Cl.: H01S 3/13

(54) **WAVELENGTH ALIGNMENT METHOD AND DEVICE, AND OPTICAL NETWORK SYSTEM**

(71) Applicant: Huawei Technologies Co., Ltd., Longgang District Shenzhen, Guangdong 518129 (CN)
(72) Inventor: LIAO, Zhenxing, Shenzhen Guangdong 518129 (CN); CHENG, Ning, Shenzhen Guangdong 518129 (CN); ZHOU, Min, Shenzhen Guangdong 518129 (CN); HUANG, Jing, Shenzhen, Guangdong 518129 (CN); WEN, Yunsheng, Shenzhen Guangdong 518129 (CN)
(74) Representative: Gill Jennings & Every LLP
(86) International application number: PCT/CN2013/079386
(87) International publication number: WO 2015/006902

(57) **Abstract**

A wavelength alignment method includes: emitting a first optical signal by using a laser; filtering the first optical signal by using a filter, and then transmitting a second optical signal; monitoring an extinction ratio of the second optical signal and an optical power of the second optical signal; and adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented. Correspondingly, embodiments of the present invention further provide a wavelength alignment apparatus, an optical transmitter and an optical network system.

## Description

### TECHNICAL FIELD

The present invention relates to the field of optical fiber networks, and in particular, to a wavelength alignment method and apparatus, an optical transmitter, and an optical network system.

### BACKGROUND

With the increasingly high requirements of users for bandwidth and the gradual maturation of fiber-optic communications technologies, a fiber access network has gradually become a powerful competitor of a broadband access network, in which a PON (Passive Optical Network, passive optical network) system is particularly more competitive.

Because a DML (Directly Modulated Laser, directly modulated laser) has significant advantages in aspects such as costs and output power, people consider that an optical module on an OLT (Optical Line Terminal, optical line terminal) side of a PON system is implemented by using the DML.

However, the DML modulates output of a semi-conductor laser by changing an injected current, and this modulation scheme leads to a change in a refractive index of an active layer, thereby causing it difficult to implement wavelength alignment of the DML and a filter.

### SUMMARY

Embodiments of the present invention provide a wavelength alignment method and apparatus, an optical transmitter, and an optical network system, which are used to resolve a problem about high difficulty of wavelength alignment in the prior art.

In order to resolve the foregoing technical problem, technical solutions used in the embodiments of the present invention are as follows:

According to a first aspect, an embodiment of the present invention provides a wavelength alignment method, including:
emitting a first optical signal by using a laser;
filtering the first optical signal by using a filter, and then transmitting a second optical signal;
monitoring an extinction ratio of the second optical signal and an optical power of the second optical signal; and
adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.

In a first possible implementation manner of the first aspect, the working temperature of the laser is controlled by a first temperature control apparatus, or the working temperature of the laser and the working temperature of the filter are both controlled by a first temperature control apparatus; and
the adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented specifically includes:
adjusting an output temperature of the first temperature control apparatus to decrease to a first target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented; or
adjusting an output temperature of the first temperature control apparatus to increase to a second target temperature when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented.

In a second possible implementation manner of the first aspect, the working temperature of the filter is controlled by a first temperature control apparatus, and the working temperature of the laser is controlled by a second temperature control apparatus;
an output temperature of the second temperature control apparatus is preset to a preset upper limit of the working temperature of the laser; and
the adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented specifically includes:
adjusting an output temperature of the first temperature control apparatus to decrease to a third target temperature or turning off the first temperature control apparatus when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented; or
adjusting an output temperature of the first temperature control apparatus to increase to a fourth target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented.

With reference to the second possible implementation manner of the first aspect, in a third possible implementation manner, the method further includes: measuring an initial ambient temperature at a position that is away from the filter by a distance within a preset range when adjusting an initial value of the working temperature of the laser and/or an initial value of the working temperature of the filter;
monitoring a real-time ambient temperature at the position that is away from the filter by the distance within the preset range; and
adjusting the output temperature of the first temperature control apparatus to increase to a fifth target temperature when the real-time ambient temperature is higher than the initial ambient temperature, so that wavelength alignment of the filter and the laser is implemented; or
adjusting the output temperature of the first temperature control apparatus to decrease to a sixth target temperature or turning off the first temperature control apparatus when the real-time ambient temperature is lower than the initial ambient temperature, so that wavelength alignment of the filter and the laser is implemented.

According to a second aspect, an embodiment of the present invention provides a wavelength alignment apparatus, including:
a monitoring unit, configured to monitor an extinction ratio of a second optical signal and an optical power of the second optical signal, where the second optical signal is an optical signal that is transmitted by a filter after the filter filters a first optical signal emitted by a laser; and
a micro-control unit, configured to receive the extinction ratio and optical power of the second optical signal that are fed back by the monitoring unit; and adjust a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.

In a first possible implementation manner of the second aspect, the micro-control unit is configured to: adjust an output temperature of a first temperature control apparatus to decrease to a first target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented, where the first temperature control apparatus is configured to control the working temperature of the laser, or the first temperature control apparatus is configured to control the working temperature of the laser and the working temperature of the filter; and adjust the output temperature of the first temperature control apparatus to increase to a second target temperature when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented.

In a second possible implementation manner of the second aspect, the micro-control unit is configured to: preset an output temperature of a second temperature control apparatus to a preset upper limit of the working temperature of the laser, where the second temperature control apparatus is configured to control the working temperature of the laser; adjust an output temperature of a first temperature control apparatus to decrease to a third target temperature or turn off a first temperature control apparatus when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented, where the first temperature control apparatus is configured to control the working temperature of the filter; and adjust the output temperature of the first temperature control apparatus to increase to a fourth target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented.

With reference to the second possible implementation manner of the second aspect, in a third possible implementation manner, the micro-control unit is further configured to: measure an initial ambient temperature at a position that is away from the filter by a distance within a preset range when adjusting an initial value of the working temperature of the laser and/or an initial value of the working temperature of the filter; monitor a real-time ambient temperature at the position that is away from the filter by the distance within the preset range; adjust the output temperature of the first temperature control apparatus to increase to a fifth target temperature when the real-time ambient temperature is higher than the initial ambient temperature, so that wavelength alignment of the filter and the laser is implemented; and adjust the output temperature of the first temperature control apparatus to decrease to a sixth target temperature or turn off the first temperature control apparatus when the real-time ambient temperature is lower than the initial ambient temperature, so that wavelength alignment of the filter and the laser is implemented.

According to a third aspect, an embodiment of the present invention provides an optical transmitter, including a laser, a filter, and the wavelength alignment apparatus according to the foregoing embodiment of the present invention.

According to a fourth aspect, an embodiment of the present invention provides an optical network system, including: an optical line terminal OLT and an optical network unit, where the optical line terminal and/or the optical network unit includes at least the optical transmitter according to the foregoing embodiment of the present invention.

According to the foregoing solutions, the embodiments of the present invention provide a wavelength alignment method and apparatus, an optical transmitter, and an optical network system. It is found that, when an extinction ratio and optical power of a second optical signal that is transmitted by a filter after the filter filters a first optical signal emitted by a laser keeps within respective threshold ranges, the laser and the filter are in a wavelength aligned state; and when wavelengths of the laser and the filter are not aligned, the extinction ratio and optical power of the second optical signal exceed the respective threshold ranges. Therefore, the present invention achieves wavelength alignment of the filter and the laser by monitoring a change in the extinction ratio and optical power of the second optical signal. That is, when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, a working temperature of the laser and/or a working temperature of the filter is adjusted to a target working temperature, so that wavelength alignment of the filter and the laser is implemented, thereby overcoming a problem about high difficulty of implementation in the prior art.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a first schematic flowchart of a method according to an embodiment of the present invention;
FIG. 2 is a second schematic flowchart of a method according to an embodiment of the present invention;
FIG. 3 is a third schematic flowchart of a method according to an embodiment of the present invention;
FIG. 4 is a schematic structural diagram of an apparatus according to an embodiment of the present invention;
FIG. 5 is a first schematic structural diagram of an optical transmitter according to an embodiment of the present invention;
FIG. 6 is a second schematic structural diagram of an optical transmitter according to an embodiment of the present invention;
FIG. 7 is a third schematic structural diagram of an optical transmitter according to an embodiment of the present invention; and
FIG. 8 is a schematic structural diagram of an optical network system according to an embodiment of the present invention.

### DESCRIPTION OF EMBODIMENTS

In order to enable a person skilled in the art to better understand the solutions in the embodiments of the present invention, the following describes the embodiments of the present invention in more detail with reference to accompanying drawings and implementation manners.

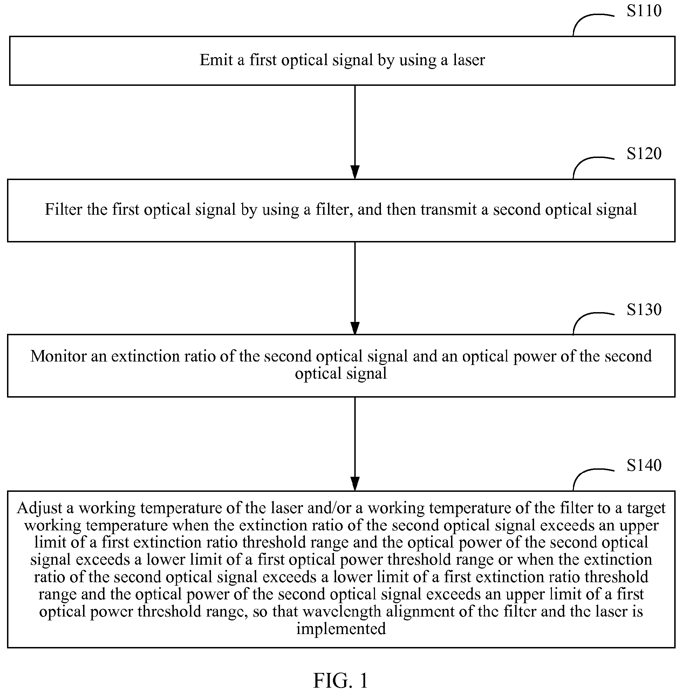

Refer to FIG. 1, which shows a flowchart of a wavelength alignment method according to an embodiment of the present invention. As shown in the figure, this embodiment of the present invention may include:
S110: Emit a first optical signal by using a laser.
S120: Filter the first optical signal by using a filter, and then transmit a second optical signal.

For example, in this embodiment of the present invention, the laser may be a DML (directly modulated laser), and the filter may be a narrowband optical filter.

S130: Monitor an extinction ratio of the second optical signal and an optical power of the second optical signal.

S140: Adjust a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.

During application of this embodiment of the present invention, by simply monitoring a change in an extinction ratio and optical power of a second optical signal that is transmitted by a filter after the filter filters a first optical signal emitted by a laser, it can be determined that the laser and the filter are in a non-wavelength aligned state when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range; and then wavelength alignment of the filter and the laser is implemented by adjusting a working temperature of the laser and/or a working temperature of the filter to a target working temperature. The wavelength alignment method is simple, low in costs, and is easily implemented, so that an optical transmitter based on a DML can be practically applied.

In this embodiment of the present invention, according to a principle that relative positions of a wavelength of the first optical signal emitted by the laser and a transmission spectrum of the filter vary with a temperature change, the working temperature of the laser and/or the working temperature of the filter is adjusted to the target working temperature, so that the laser and the filter are in a wavelength aligned state. It should be noted that, the target working temperature may vary in different implementation manners. For example, in the following embodiments, the target working temperature may include a first target temperature, a second target temperature, a third target temperature, a fourth target temperature, a fifth target temperature, or a sixth target temperature. The following describes in detail this embodiment of the present invention by using several possible implementation manners of adjusting a working temperature of a laser and/or a working temperature of an optical filter.

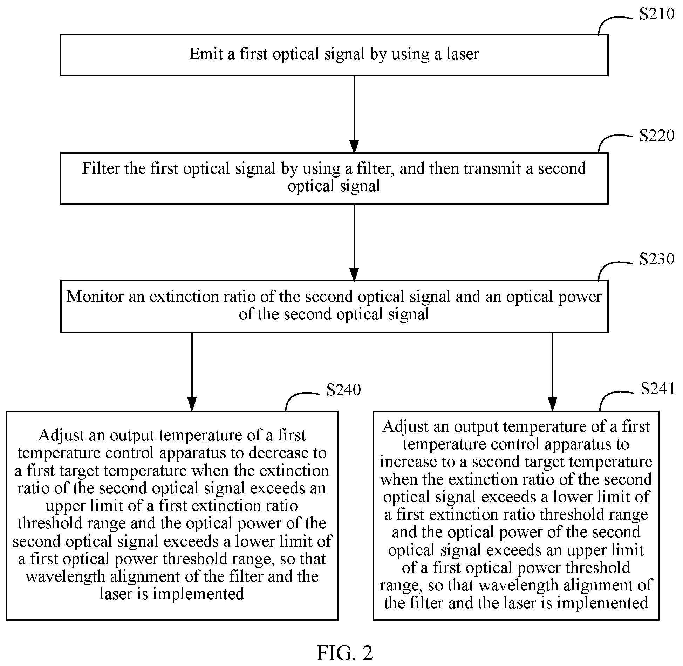

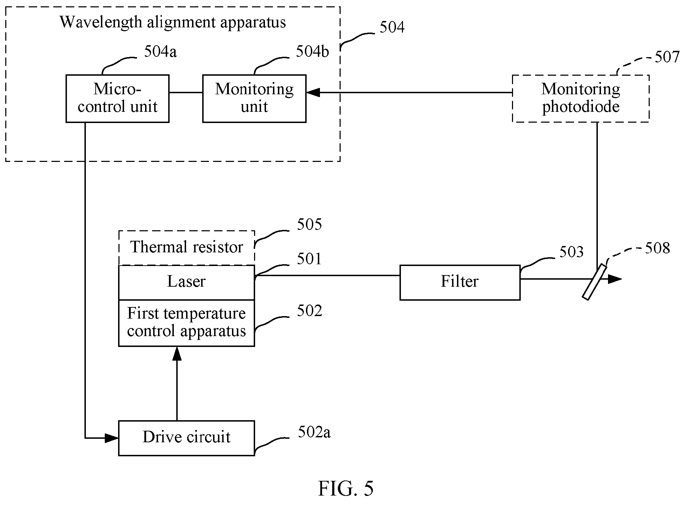

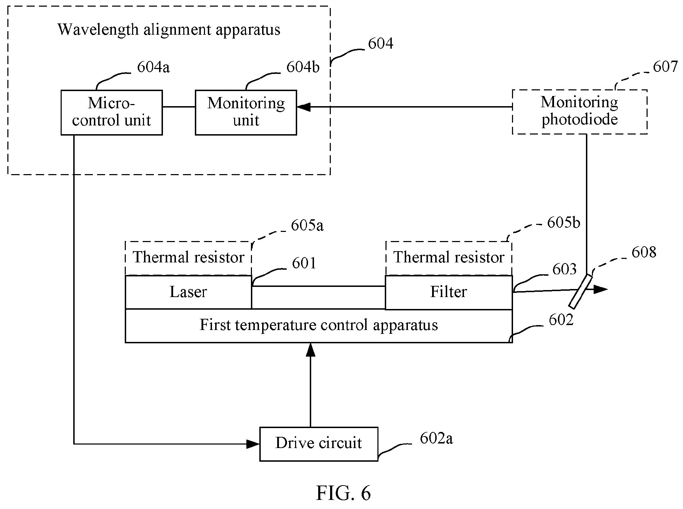

Refer to FIG. 2, which shows a flowchart of a possible implementation manner of a wavelength alignment method according to an embodiment of the present invention. In this embodiment, only a working temperature of a laser may be adjusted by using a first temperature control apparatus, as shown in FIG. 5, or both a working temperature of a laser and a working temperature of a filter may be adjusted by using a first temperature control apparatus, as shown in FIG. 6. The method provided in this embodiment may include:
S210: Emit a first optical signal by using a laser.
S220: Filter the first optical signal by using a filter, and then transmit a second optical signal.
S230: Monitor an extinction ratio of the second optical signal and an optical power of the second optical signal.
S240: Adjust an output temperature of a first temperature control apparatus to decrease to a first target temperature when the extinction ratio of the second optical signal exceeds an upper limit of a first extinction ratio threshold range and the optical power of the second optical signal exceeds a lower limit of a first optical power threshold range, so that wavelength alignment of the filter and the laser is implemented.
S241: Adjust an output temperature of a first temperature control apparatus to increase to a second target temperature when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.

It should be noted that, in this embodiment of the present invention, the output temperature of the first temperature control apparatus is adjusted to decrease to the first target temperature, or the output temperature of the first temperature control apparatus is adjusted to increase to the second target temperature, where the first target temperature and the second target temperature may be obtained through calculation according to an algorithm by using an amount by which the detected extinction ratio exceeds the first extinction ratio threshold range and an amount by which the detected optical power exceeds the first optical power threshold range; or while the output temperature of the first temperature control apparatus is gradually adjusted to increase or decrease by a preset minimum adjustment amount, an extinction ratio and optical power after the output temperature is changed are monitored, where it may be determined that the first target temperature or the second target temperature is reached when the extinction ratio and optical power respectively fall within the first extinction ratio threshold range and the first optical power threshold range. Therefore, a specific implementation manner of adjusting an output temperature of a first temperature control apparatus to decrease to a first target temperature or increase to a second target temperature may be set according to implementation requirements, which is not limited in the present invention.

It can be understood that, when the first temperature control apparatus is configured to control only the working temperature of the laser, the filter does not need to share the first temperature control apparatus with the laser, and the filter does not need to be cooled and can be externally disposed, which is more flexible in practical application. In addition, to enable relative positions of the wavelength of the first optical signal emitted by the laser and a transmission spectrum of the filter to rapidly change, and to rapidly and accurately implement wavelength alignment, a narrowband optical filter that has a good temperature stability and is made of silicon dioxide may be used, of which a typical temperature coefficient is 0.01 nm/°C, a working temperature range is within 0°C to 70°C, and a maximum wavelength shift is 0.7 nm, which meets requirements for rapidly and accurately implementing wavelength alignment.

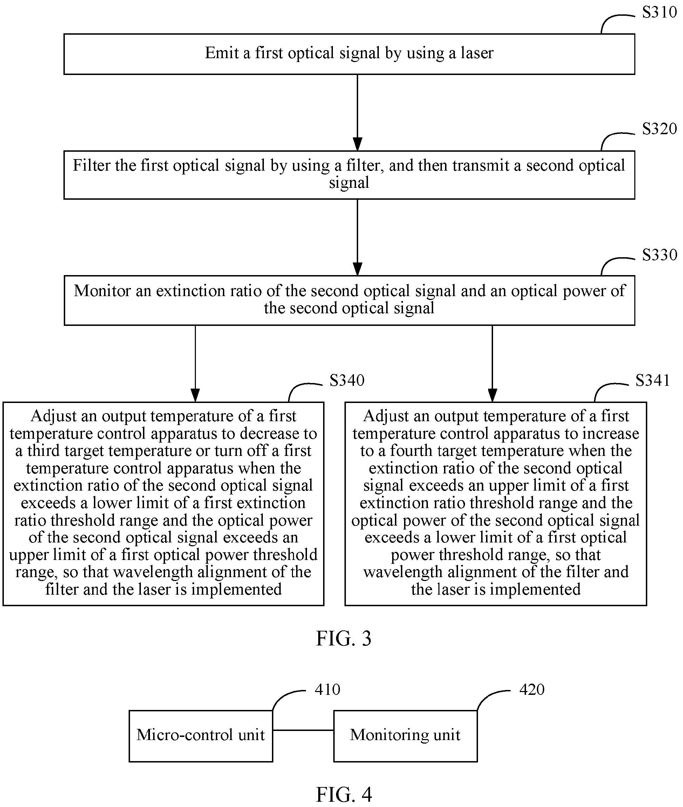

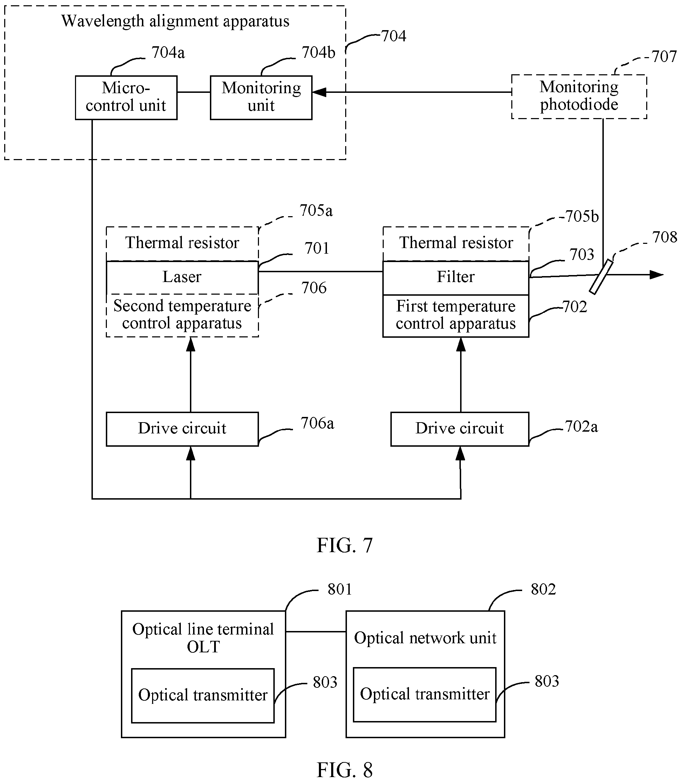

Refer to FIG. 3, which shows a flowchart of another possible implementation manner of a wavelength alignment method according to an embodiment of the present invention. In this embodiment, a first temperature control apparatus may be used to adjust a working temperature of a filter, as shown in FIG. 7, and a second temperature control apparatus may be further used to adjust a working temperature of a laser. In addition, an output temperature of the second temperature control apparatus is preset to a preset upper limit of the working temperature of the laser. The method provided in this embodiment may include:
S310: Emit a first optical signal by using a laser.
S320: Filter the first optical signal by using a filter, and then transmit a second optical signal.
S330: Monitor an extinction ratio of the second optical signal and an optical power of the second optical signal.
S340: Adjust an output temperature of a first temperature control apparatus to decrease to a third target temperature or turn off a first temperature control apparatus when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.
S341: Adjust an output temperature of a first temperature control apparatus to increase to a fourth target temperature when the extinction ratio of the second optical signal exceeds an upper limit of a first extinction ratio threshold range and the optical power of the second optical signal exceeds a lower limit of a first optical power threshold range, so that wavelength alignment of the filter and the laser is implemented.

In this embodiment, a temperature control platform of the laser is separated from a temperature control platform of the filter. That is, the first temperature control apparatus is used to control the working temperature of the filter, and the second temperature control apparatus is used to control the working temperature of the laser. Because the separate temperature control platforms are used, an initial output temperature of the second temperature control apparatus is preset to a preset upper limit (such as 50°C to 70°C) of the working temperature of the laser, to make laser light emitted by the laser have a relatively small wavelength shift, thereby meeting requirements of a standard. Therefore, wavelength alignment can be implemented by only controlling the working temperature of the filter by adjusting the output temperature of the first temperature control apparatus. Moreover, because the filter has no additional heating source, cooling requirements are lowered or canceled, which further reduces power consumption as compared with the previous embodiments.

In this embodiment, because the output temperature of the second temperature control apparatus is preset to the preset upper limit of the working temperature of the laser, the second temperature control apparatus may be a heater that has only a heating function, and the first temperature control apparatus may be a thermoelectric cooler (TEC); or when an implementation manner of turning off the first temperature control apparatus is used, the first temperature control apparatus may be a heater that has only a heating function.

Considering that in addition to the first temperature control apparatus, the narrowband optical filter has no additional heating source, a change in an ambient temperature also leads to a change in the relative positions of the wavelength of the first optical signal emitted by the laser and the optical spectrum of the filter. Therefore, in order to make up for impact caused by the ambient temperature change, when the ambient temperature rises, the temperature of the first temperature control apparatus may be controlled to increase so that the spectrum of the filter has a higher wavelength redshift speed; and when the ambient temperature drops, the temperature of the first temperature control apparatus is controlled to decrease or the first temperature control apparatus is turned off, so that the spectrum of the filter has a higher wavelength blueshift speed, thereby ensuring wavelength alignment of the DML and the narrowband optical filter. Specifically, the method may include:
measuring an initial ambient temperature at a position that is away from the filter by a distance within a preset range when adjusting an initial value of the working temperature of the laser and/or an initial value of the working temperature of the filter;
monitoring a real-time ambient temperature at the position that is away from the filter by the distance within the preset range; and
adjusting the output temperature of the first temperature control apparatus to increase to a fifth target temperature when the real-time ambient temperature is higher than the initial ambient temperature, so that wavelength alignment of the filter and the laser is implemented; or
adjusting the output temperature of the first temperature control apparatus to decrease to a sixth target temperature or turning off the first temperature control apparatus when the real-time ambient temperature is lower than the initial ambient temperature, so that wavelength alignment of the filter and the laser is implemented.

In addition, to rapidly implement wavelength alignment and reduce chirps, in this embodiment of the present invention, by using a DML (directly modulated laser) as an example, the following initialization process is provided. For example, the initialization process may be executed before the extinction ratio and optical power of the second optical signal are monitored in real time, and may include:
setting an initial bias current of a DML (directly modulated laser);
setting a first initial output temperature of the first temperature control apparatus, so that the optical power of the second optical signal reaches a maximum value; and
setting a modulated current of the DML and a second initial output temperature of the first temperature control apparatus, so that a frequency chirp of the second optical signal is within a preset chirp range and the extinction ratio of the second optical signal is within a preset second extinction ratio threshold range.

It should be noted that, a proper modulated current of the DML and a proper second initial output temperature may be set according to the preset second extinction ratio threshold range and the preset chirp range. The preset chirp range may be determined according to practical application requirements. For example, a standard emission wavelength for a 10G PON OLT is defined as 1,575 nm to 1,580 nm; standard SMF-28 optical fibers that are widely used in PONs within this wavelength range have a dispersion coefficient of about 18 ps/(nm·km); and a typical transmission distance of a PON network is 20 km. In an NRZ modulation system, under a condition of a limited dispersion penalty, it is ensured that a maximum dispersion broadening amount (chirp) ΔT shall be generally less than or equal to half of a bit width, that is, 10 Gbps corresponds to 0.5*100 ps. Therefore, downlink transmission of a 10G PON needs to meet AT=18 ps/(nm·km)*20 km*Δλ≤50 ps, where Δλ is 2δ of a line width of an emitting laser.

The second initial output temperature of the first temperature control apparatus may be set according to empirical values obtained from multiple tests, or set by performing the following steps, which, for example, may include: monitoring the extinction ratio and optical power of the second optical signal; adjusting a current working temperature of the laser and/or a current working temperature of the filter when the extinction ratio of the second optical signal exceeds an upper limit of the second extinction ratio threshold range and the optical power of the second optical signal exceeds a lower limit of a second optical power threshold range or when the extinction ration of the second optical signal exceeds a lower limit of the second extinction ratio threshold range and the optical power of the second optical signal exceeds an upper limit of a second optical power threshold range, where if the second extinction ratio threshold range is within the first extinction ratio threshold range, and the second optical power threshold range is within the first optical power threshold range, and going back to the step of monitoring the extinction ratio and optical power of the second optical signal; or otherwise, terminating adjustment on the initial value of the working temperature of the laser and/or the initial value of the working temperature of the filter.

It should be noted that, the first extinction ratio threshold range and the first optical power threshold range may be obtained according to empirical values obtained from multiple tests; or the first extinction ratio threshold range and the first optical power threshold range may be obtained through calculation according to the detected extinction ratio and optical power when the extinction ratio of the second optical signal does not exceed the preset second extinction ratio threshold range and the optical power of the second optical signal does not exceed the preset second optical power threshold range. A specific calculation method may be set according to implementation requirements. For example, an allowable extinction ratio offset and optical power offset may be preset, and the detected extinction ratio and optical power may be increased or decreased according to the extinction ratio offset and the optical power offset, thereby obtaining the first extinction ratio threshold range and the first optical power threshold range.

It should be further noted that, in this embodiment of the present invention, the monitoring the extinction ratio and optical power of the second optical signal may be implemented by reading an extinction ratio and optical power that are output by a monitoring photodiode, where the monitoring photodiode is configured to receive an optical signal from an optical splitter that reflects the second optical signal transmitted by the filter, and output an extinction ratio and optical power of the optical signal.

In addition, during practical application, whether wavelengths of the laser and the filter are aligned needs to be monitored in real time so as to maintain an aligned state. Therefore, after the adjusting a working temperature of the laser and/or a working temperature of the filter to a target working temperature, so that wavelength alignment of the filter and the laser is implemented, the method may further include going back to the step of monitoring an extinction ratio and optical power of the second optical signal, thereby maintaining the laser and the filter in a wavelength aligned state by means of real-time monitoring on the extinction ratio and optical power.

Considering that when wavelength non-alignment of the laser and the filter is relatively significant, a case in which the extinction ratio decreases and the optical power also decreases may occur, and in this case, the bias current and modulated current of the laser such as a DML (directly modulated laser) need to be increased, so as to adjust a change in the relative positions of the wavelength of the first optical signal emitted by the laser and the transmission spectrum of the filter. Therefore, the method in this embodiment of the present invention may further include?: increasing the bias current and modulated current of the DML when the extinction ratio of the second optical signal exceeds the lower limit of the first extinction ratio threshold range and the optical power of the second optical signal exceeds the lower limit of the first optical power threshold range.

Corresponding to the foregoing method embodiments, an embodiment of the present invention further provides a wavelength alignment apparatus. The apparatus may be applied to an optical transmitter including a laser and a filter. As shown in FIG. 4, the apparatus may include:
a monitoring unit 410, configured to monitor an extinction ratio of a second optical signal and an optical power of the second optical signal, where the second optical signal is an optical signal that is transmitted by a filter after the filter filters a first optical signal emitted by a laser; and
a micro-control unit 420, configured to receive the extinction ratio and optical power of the second optical signal that are fed back by the monitoring unit; and adjust a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.

According to a principle that relative positions of a wavelength of the second optical signal emitted by the laser and a transmission spectrum of the filter vary with a temperature change, in this embodiment of the present invention, wavelengths of the laser and the filter are aligned by adjusting the working temperature of the laser and/or the working temperature of the filter. For example, the micro-control unit 420 may be configured to: adjust an output temperature of a first temperature control apparatus to decrease to a first target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented, where the first temperature control apparatus is configured to control the working temperature of the laser, or the first temperature control apparatus is configured to control the working temperature of the laser and the working temperature of the filter; and adjust the output temperature of the first temperature control apparatus to increase to a second target temperature when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented.

Alternatively, the micro-control unit 420 may be configured to: preset an output temperature of a second temperature control apparatus to a preset upper limit of the working temperature of the laser, where the second temperature control apparatus is configured to control the working temperature of the laser; adjust an output temperature of a first temperature control apparatus to decrease to a third target temperature or turn off a first temperature control apparatus when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented, where the first temperature control apparatus is configured to control the working temperature of the filter; and adjust the output temperature of the first temperature control apparatus to increase to a fourth target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented.

In this embodiment, to make up for impact caused by an ambient temperature to a narrowband optical filter, the micro-control unit 420 may be further configured to: measure an initial ambient temperature at a position that is away from the filter by a distance within a preset range when adjusting an initial value of the working temperature of the laser and/or an initial value of the working temperature of the filter; monitor a real-time ambient temperature at the position that is away from the filter by the distance within the preset range; adjust the output temperature of the first temperature control apparatus to increase to a fifth target temperature when the real-time ambient temperature is higher than the initial ambient temperature, so that wavelength alignment of the filter and the laser is implemented; and adjust the output temperature of the first temperature control apparatus to decrease to a sixth target temperature or turn off the first temperature control apparatus when the real-time ambient temperature is lower than the initial ambient temperature, so that wavelength alignment of the filter and the laser is implemented.

In addition, the wavelength alignment apparatus provided in this embodiment of the present invention may further include an initializing unit, which may be configured to: set an initial bias current of a DML; set a first initial output temperature of the first temperature control apparatus, so that the optical power of the second optical signal reaches a maximum value; and set a modulated current of the DML and a second initial output temperature of the first temperature control apparatus, so that a frequency chirp of the second optical signal is within a preset chirp range and the extinction ratio of the second optical signal is within a preset second extinction ratio threshold range.

It should be noted that, the monitoring unit 410 provided in this embodiment of the present invention may be configured to: read an extinction ratio and optical power that are output by a monitoring photodiode, where the monitoring photodiode is configured to receive an optical signal from an optical splitter that reflects the second optical signal transmitted by the filter, and output an extinction ratio and optical power of the optical signal.

Considering a requirement for real-time locking on wavelength alignment of the laser and the filter, the micro-control unit 420 may be further configured to: after adjusting the working temperature of the laser and/or the working temperature of the filter to the target working temperature, so that wavelength alignment of the filter and the laser is implemented, trigger the monitoring unit 410 to continue to monitor the extinction ratio and optical power of the second optical signal.

For a case in which wavelength non-alignment of the DML and the filter is relatively significant, and the extinction ratio may decrease and the optical power also may decrease, the micro-control unit 420 provided in this embodiment of the present invention may be further configured to: increase the bias current and modulated current of the DML when the extinction ratio of the second optical signal exceeds the lower limit of the first extinction ratio threshold range and the optical power of the second optical signal exceeds the lower limit of the first optical power threshold range.

The following further describes in detail an optical transmitter provided in an embodiment of the present invention.

For example, refer to FIG. 5, which is a schematic structural diagram of a possible implementation manner of the optical transmitter according to this embodiment of the present invention. As shown in the figure, the optical transmitter may include a laser 501, a filter 503, and a wavelength alignment apparatus 504 as described in the foregoing embodiment of the present invention.

A micro-control unit 504a of the wavelength alignment apparatus 504 may be connected to a drive circuit 502a of a first temperature control apparatus 502, and the first temperature control apparatus 502 may be configured to control only a working temperature of the laser 501.

The optical transmitter shown in FIG. 5 may further include a thermal resistor 505, configured to control heat transfer between the first temperature control apparatus 502 and the DML 501. A monitoring unit 504b of the wavelength alignment apparatus 504 may be configured to read an extinction ratio and optical power that are output by a monitoring photodiode 507. The monitoring photodiode 507 may be configured to receive an optical signal from an optical splitter 508 that reflects a second optical signal transmitted by the filter 503, and output an extinction ratio and optical power of the optical signal.

For example, refer to FIG. 6, which is a schematic structural diagram of another possible implementation manner of the optical transmitter according to this embodiment of the present invention. As shown in FIG. 6, the optical transmitter may include a laser 601, a filter 603, and a wavelength alignment apparatus 604 as described in this embodiment of the present invention.

A micro-control unit 604a of the wavelength alignment apparatus 604 may be connected to a drive circuit 602a of a first temperature control apparatus 602, and the first temperature control apparatus 602 may be configured to control both a working temperature of the laser 601 and a working temperature of the filter 603.

The optical transmitter shown in FIG. 6 may further include thermal resistors 605a and 605b, configured to control heat transfer between the first temperature control apparatus 602 and the DML 601 and heat transfer between the first temperature control apparatus 602 and the narrowband optical filter 603, respectively. A monitoring unit 604b of the wavelength alignment apparatus 604 may be configured to read an extinction ratio and optical power that are output by a monitoring photodiode 607. The monitoring photodiode 607 may be configured to receive an optical signal from an optical splitter 608 that reflects a second optical signal transmitted by the filter, and output an extinction ratio and optical power of the optical signal.

For example, refer to FIG. 7, which is a schematic structural diagram of still another possible implementation manner of the optical transmitter according to this embodiment of the present invention. As shown in FIG. 7, the optical transmitter may include a laser 701, a filter 703, and a wavelength alignment apparatus 704 described in this embodiment of the present invention.

A micro-control unit 704a of the wavelength alignment apparatus 704 may be connected to a drive circuit 702a of a first temperature control apparatus 702 and a drive circuit 706a of a second temperature control apparatus 706. The first temperature control apparatus 702 may be configured to control a working temperature of the filter; and the second temperature control apparatus 706 may be configured to control a working temperature of the laser 701.

The optical transmitter shown in FIG. 7 may further include a thermal resistor 705a, configured to control heat transfer between the first temperature control apparatus and the DML; and a thermal resistor 705b, configured to control heat transfer between the second temperature control apparatus 702 and the narrowband optical filter 703. A monitoring unit 704b of the wavelength alignment apparatus may be configured to read an extinction ratio and optical power that are output by a monitoring photodiode 707. The monitoring photodiode 707 may be configured to receive an optical signal from an optical splitter 708 that reflects a second optical signal transmitted by the filter, and output an extinction ratio and optical power of the optical signal.

In addition, in the optical transmitter provided in this embodiment of the present invention, a first optical signal emitted by the laser may enter the filter through an optical isolator and a collimation lens.

The following further describes in detail an optical network system provided in an embodiment of the present invention.

Refer to FIG. 8, which is a schematic structural diagram of the optical network system according to this embodiment of the present invention. As shown in the figure, the optical network system may include an optical line terminal OLT 801 and an optical network unit 802, where the optical line terminal 801 and/or the optical network unit 802 includes at least an optical transmitter 803 as described in this embodiment of the present invention.

Further, this embodiment of the present invention further provides hardware composition of a wavelength alignment apparatus, which may include at least one processor (such as a CPU or a micro-control unit MCU), at least one communications interface, a memory, and at least one communications bus that is configured to implement connection and communication between units and devices. The processor is configured to execute an executable module that is stored in the memory, such as a computer program. The memory may include a high speed random access memory (RAM: Random Access Memory), and may further include a non-volatile memory (non-volatile memory), for example, at least one magnetic disk storage.

In some implementation manners, the memory stores a program instruction, and the program instruction may be executed by the processor. The program instruction is used for executing the method of the embodiments of the present invention, which may include, for example, monitoring an extinction ratio of a second optical signal and an optical power of the second optical signal, where the second optical signal is an optical signal transmitted by a filter after the filter filters a first optical signal emitted by a laser; and adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented. It can be understood that, the method, executed by the program instruction, of the embodiments of the present invention may include the method of the embodiments described in this specification and other implementation manners based on the method of the embodiments of the present invention. Details are not described herein again.

It can be known from the description of the foregoing implementation manners that, a person skilled in the art can clearly understand that all or some steps of the foregoing method embodiments may be implemented by means of software plus a necessary common hardware platform. Based on such an understanding, the technical solutions of the present invention essentially or the part contributing to the prior art may be implemented in a form of a software product. The computer software product is stored in a storage medium, such as a ROM/RAM, a magnetic disk, or an optical disc, and includes several instructions for instructing a computer device (which may be a personal computer, a server, a network communications device such as a media gateway, or the like) to perform the method described in the embodiments or some parts of the embodiments of the present invention.

It should be noted that the embodiments in this specification are all described in a progressive manner, for same or similar parts in the embodiments, reference may be made to these embodiments, and each embodiment focuses on a difference from other embodiments. Especially, device and system embodiments are basically similar to a method embodiment, and therefore are described briefly; for related parts, reference may be made to partial descriptions in the method embodiment. The described device and system embodiments are merely exemplary. The units described as separate parts may or may not be physically separate, and parts displayed as units may or may not be physical units, may be located in one position, or may be distributed on a plurality of network units. Some or all of the modules may be selected according to actual requirements to achieve the objectives of the solutions of the embodiments. A person of ordinary skill in the art may understand and implement the embodiments of the present invention without creative efforts.

The foregoing descriptions are merely exemplary embodiments of the present invention, but are not intended to limit the protection scope of the present invention. Any modification, equivalent replacement, or improvement made without departing from the spirit and principle of the present invention shall fall within the protection scope of the present invention.

## Claims

1. A wavelength alignment method, comprising:
emitting a first optical signal by using a laser;
filtering the first optical signal by using a filter, and then transmitting a second optical signal;
monitoring an extinction ratio of the second optical signal and an optical power of the second optical signal; and
adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.

2. The method according to claim 1, wherein the working temperature of the laser is controlled by a first temperature control apparatus, or the working temperature of the laser and the working temperature of the filter are both controlled by a first temperature control apparatus; and
the adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented specifically comprises:
adjusting an output temperature of the first temperature control apparatus to decrease to a first target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented; or
adjusting an output temperature of the first temperature control apparatus to increase to a second target temperature when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented.

3. The method according to claim 1, wherein the working temperature of the filter is controlled by a first temperature control apparatus, and the working temperature of the laser is controlled by a second temperature control apparatus;
an output temperature of the second temperature control apparatus is preset to a preset upper limit of the working temperature of the laser; and
the adjusting a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented specifically comprises:
adjusting an output temperature of the first temperature control apparatus to decrease to a third target temperature or turning off the first temperature control apparatus when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented; or
adjusting an output temperature of the first temperature control apparatus to increase to a fourth target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented.

4. The method according to claim 3, further comprising:
measuring an initial ambient temperature at a position that is away from the filter by a distance within a preset range when adjusting an initial value of the working temperature of the laser and/or an initial value of the working temperature of the filter;
monitoring a real-time ambient temperature at the position that is away from the filter by the distance within the preset range; and
adjusting the output temperature of the first temperature control apparatus to increase to a fifth target temperature when the real-time ambient temperature is higher than the initial ambient temperature, so that wavelength alignment of the filter and the laser is implemented; or
adjusting the output temperature of the first temperature control apparatus to decrease to a sixth target temperature or turning off the first temperature control apparatus when the real-time ambient temperature is lower than the initial ambient temperature, so that wavelength alignment of the filter and the laser is implemented.

5. A wavelength alignment apparatus, comprising:
a monitoring unit, configured to monitor an extinction ratio of a second optical signal and an optical power of the second optical signal, wherein the second optical signal is an optical signal that is transmitted by a filter after the filter filters a first optical signal emitted by a laser; and
a micro-control unit, configured to receive the extinction ratio and optical power of the second optical signal that are fed back by the monitoring unit; and adjust a working temperature of the laser and/or a working temperature of the filter to a target working temperature when the extinction ratio of the second optical signal exceeds an upper limit of a first extinction ratio threshold range and the optical power of the second optical signal exceeds a lower limit of a first optical power threshold range or when the extinction ratio of the second optical signal exceeds a lower limit of a first extinction ratio threshold range and the optical power of the second optical signal exceeds an upper limit of a first optical power threshold range, so that wavelength alignment of the filter and the laser is implemented.

6. The apparatus according to claim 5, wherein the micro-control unit is configured to: adjust an output temperature of a first temperature control apparatus to decrease to a first target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented, wherein the first temperature control apparatus is configured to control the working temperature of the laser, or the first temperature control apparatus is configured to control the working temperature of the laser and the working temperature of the filter; and adjust the output temperature of the first temperature control apparatus to increase to a second target temperature when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented.

7. The apparatus according to claim 5, wherein the micro-control unit is configured to: preset an output temperature of a second temperature control apparatus to a preset upper limit of the working temperature of the laser, wherein the second temperature control apparatus is configured to control the working temperature of the laser; adjust an output temperature of a first temperature control apparatus to decrease to a third target temperature or turn off a first temperature control apparatus when the extinction ratio of the second optical signal exceeds the lower limit of the first extinction ratio threshold range and the optical power of the second optical signal exceeds the upper limit of the first optical power threshold range, so that wavelength alignment of the filter and the laser is implemented, wherein the first temperature control apparatus is configured to control the working temperature of the filter; and adjust the output temperature of the first temperature control apparatus to increase to a fourth target temperature when the extinction ratio of the second optical signal exceeds the upper limit of the first extinction ratio threshold range and the optical power of the second optical signal exceeds the lower limit of the first optical power threshold range, so that wavelength alignment of the filter and the laser is implemented.

8. The apparatus according to claim 7, wherein the micro-control unit is further configured to:
measure an initial ambient temperature at a position that is away from the filter by a distance within a preset range when adjusting an initial value of the working temperature of the laser and/or an initial value of the working temperature of the filter; monitor a real-time ambient temperature at the position that is away from the filter by the distance within the preset range; adjust the output temperature of the first temperature control apparatus to increase to a fifth target temperature when the real-time ambient temperature is higher than the initial ambient temperature, so that wavelength alignment of the filter and the laser is implemented; and adjust the output temperature of the first temperature control apparatus to decrease to a sixth target temperature or turn off the first temperature control apparatus when the real-time ambient temperature is lower than the initial ambient temperature, so that wavelength alignment of the filter and the laser is implemented.

9. An optical transmitter, comprising: a laser, a filter, and the wavelength alignment apparatus according to any one of claims 5 to 8.

10. An optical network system, comprising: an optical line terminal OLT and an optical network unit, wherein the optical line terminal and/or the optical network unit comprises at least the optical transmitter according to claim 9.
